# EUROPÄISCHE PATENTSCHRIFT

(11) **EP 2 792 618 B1**
(45) Veröffentlichungstag und Bekanntmachung des Hinweises auf die Patenterteilung: **26.02.2020**
(21) Anmeldenummer: 14000373.2
(22) Anmeldetag: 31.01.2014
(51) Int. Cl.: B65G 1/04, H01L 21/677

(54) **Einrichtung zum Lagern von in Gurtspulen aufgenommenen elektrischen Bauelementen**
Device for mounting electrical components in belt coils
Dispositif de logement d'éléments de construction électriques logés dans des bobines de ceinture

(30) Priorität: 16.04.2013 DE 102013006524
(43) Veröffentlichungstag der Anmeldung: 22.10.2014
(73) Patentinhaber: MIMOT GmbH, 79539 Lörrach (DE)
(72) Erfinder: Pfeil, Stephan, 79585 Steinen (DE)
(74) Vertreter: Müller Hoffmann & Partner

(56) Entgegenhaltungen:
- WO-A1-99/03760
- WO-A1-2008/068264
- WO-A1-2011/006598
- DE-A1- 4 036 128
- DE-A1- 10 225 332
- DE-U1-202007 016 549
- JP-A- H02 291 343
- JP-A- S61 145 002
- US-A- 5 601 252
- US-A1- 2002 073 760
- US-B1- 6 185 479

## Beschreibung

Einrichtung zum Lagern von in Gurtspulen aufgenommenen elektrischen Bauelementen Die Erfindung bezieht sich auf eine Einrichtung zum Lagern und Bereitstellen von in Gurtspulen aufgenommenen elektrischen Bauelementen für elektronische Geräte, wobei die Einrichtung zumindest eine Station zur Eingabe und/oder Ausgabe der Gurtspulen aufweist, wobei die Einrichtung mit Transportmitteln versehen ist, durch welche die Gurtspulen zwischen der Station und Ablagefächern einer Regaleinrichtung transportierbar sind. Eine derartige Einrichtung dient insbesondere der Zwischenlagerung der Bauelemente in der Nähe der Verarbeitungseinrichtungen, z.B. in der Nähe einer Montagelinie für elektrische Baugruppen.

Durch die DE202004006920 U1 ist eine Einrichtung bekannt geworden, welche eine Einrichtung zum Lagern und Bereitstellen von in Gurtspulen aufgenommenen Bauelementen für elektronische Geräte nach dem Oberbegriff des Anspruchs 1 offenbart. Die Transportmittel der besagten Einrichtung sind als Handhabungsroboter ausgebildet, der einen in der Höhe positionierbaren Greifer aufweist, welcher um eine zentrale senkrechte Achse drehbar und radial verschiebbar gelagert ist. Die Ablagefächer sind um die Greiferachse zirkulär verteilt angeordnet und zu dieser hin offen. Die scheibenförmigen runden Gurtspulen sind mit einem Spulenkörper mit einer zentralen Nabe versehen und werden in eine Eingabeöffnung der Einrichtung einzeln flach liegend eingelegt und zwischen zwei parallelen flachen Greifelementen des Greifers eingeklemmt und fixiert. Der Greifer wird sodann in Winkel und Höhe auf die Zielkoordinaten des Ablagefachs eingestellt und radial zum Ablagefach verschoben. Die Entnahme einer der Gurtspulen erfolgt in umgekehrter Reihenfolge. Sowohl die Eingabe als auch die Ausgabe einer der Gurtspulen erfordern einen Bedienereingriff, der aus Sicherheitsgründen immer erst nach Abschluss des Lagerzyklus erfolgen darf.

Der Erfindung liegt die Aufgabe zugrunde, den Bedienaufwand der Einrichtung zu verringern.

Diese Aufgabe wird durch die Erfindung gemäß Anspruch 1 gelöst. Durch die Mehrfachaufnahmemittel ist es möglich, ohne Bedienereingriff in einem Zug eine größere Anzahl von Gurtspulen selbsttätig einzugeben und in mehreren unmittelbar aufeinanderfolgenden Zyklen auf die einzelnen Ablagefächer zu verteilen. Die Ausgabe der abgelegten Gurtspulen kann mit denselben Transportmitteln und Funktionselementen ebenfalls ohne Bedienereingriff selbsttätig durchgeführt werden, indem die Gurtspulen z.B. für einen Auftrag in den Aufnahmemitteln gesammelt werden und dann in einem Zug entnommen werden können. Es ist aber auch möglich, eine zusätzliche getrennte Übergabevorrichtung und Aufnahmemittel vorzusehen, in denen z.B. die auszugebenden Gurtspulen z.B. auch während des Beladens der Aufnahmemittel für die Eingabe gesammelt werden können.

Durch die Weiterbildung nach den Unteransprüchen ist es möglich, die Handhabung der Gurtspulen in den Aufnahmemitteln von der Handhabung an den Ablagefächern zu entkoppeln und an die unterschiedlichen Bedingungen anzupassen. Der Sauggreifer nach Anspruch 3 ist in der Lage, eine Gurtspule an einer Flachseite zu greifen, ohne mit einer unmittelbar dahinter liegenden Gurtspule zu kollidieren.

Die Zwischenablage ist insbesondere so ausgebildet, das sowohl der Handhabungsroboter z.B. von unten als auch der Sauggreifer z.B. von oben auf die Gurtspule zugreifen können. Der Zwischenablage kann auch ein auf eine Flachseite der Gurtspule gerichteter optischer Sensor zu Identifizierung der Gurtspule und/oder zur Größenabtastung zugeordnet sein.

In dem Magazin kann eine große Anzahl von Gurtspulen gespeichert werden mit entsprechend großen Zeitabständen zwischen den Bedienereingriffen. Insbesondere ist es möglich, die Gurtspulen außerhalb der Einrichtung zu sammeln und die Wechselzeit zu verringern. Die in der Achsrichtung aneinandergereihten Gurtspulen können in hoher Packungsdichte gespeichert werden.

In dem Magazin benötigen die Gurtspulen eine geringe Grundfläche. Insbesondere kann eine Hubeinrichtung den Stapel der Gurtspulen nach jeder Entnahme immer so hoch heben, dass die Oberseite des Stapels z.B. mit Hilfe einer Lichtschranke eine definierte Höhenlage für den Sauggreifer einnimmt, was umgekehrt auch für das Auffüllen mit auszugebenden Gurtspulen gilt, wobei die Hubeinrichtung entsprechend abgesenkt wird.

Insbesondere erleichtert ein Schwenkfuß die Eingabe bzw. Entnahme des Magazins.

Das Magazin kann so kostengünstig hergestellt werden, dass es in größerer Anzahl auch außerhalb der Vorrichtung z.B. als Zwischenspeicher eingesetzt werden kann. Die z.B. runde Stange stellt ein einfaches Speichermittel dar, dessen Durchmesser an die genormte Nabenbohrung der Gurtspulen angepasst ist.

Die Auflageplatte nach Anspruch 7 kann so angeordnet sein, dass die Hubeinrichtung auf ihrer Unterseite ansetzen kann und die Auflageplatte mit den darüber gestapelten Gurtspulen anheben oder absenken kann.

Die Grundplatte mit dem Rahmen nach Anspruch 8 erleichtert die Handhabung des Magazins bei der Einsetzung oder Entnahme in die Einrichtung.

Die Stange kann in einfacher Weise in der Station gehalten werden, wobei das Magazin in einer bedienfreundlichen Schwenkstellung eingesetzt oder entnommen werden kann.

Mit dem Wagen nach Anspruch 10 kann das Magazin in der ein- bzw. ausgabegerechten Schrägstellung gehalten und transportiert werden, wobei das untere Stangenende in die Richtung des Schwenkfußes ragt. Der Wagen kann aber auch so ausgestaltet sein, dass das Magazin senkrecht stehend transportiert werden kann.

Im Folgenden wird die Erfindung anhand eines in der Zeichnung schematisiert dargestellten Ausführungsbeispieles näher erläutert. Es zeigen:
- Figur 1: eine seitliche Schnittansicht einer Einrichtung zum Lagern von Gurtspulen mit einem Magazin für die Gurtspulen und einem Transportwagen für das Magazin entlang der Linie I - I in Figur 2
- Figur 2: eine Draufsicht auf einen waagerechten Schnitt durch die Einrichtung mit dem Magazin entlang der Linie II - II in Figur 1,
- Figur 3: eine perspektivische Rückansicht der Einrichtung nach Figur 1,

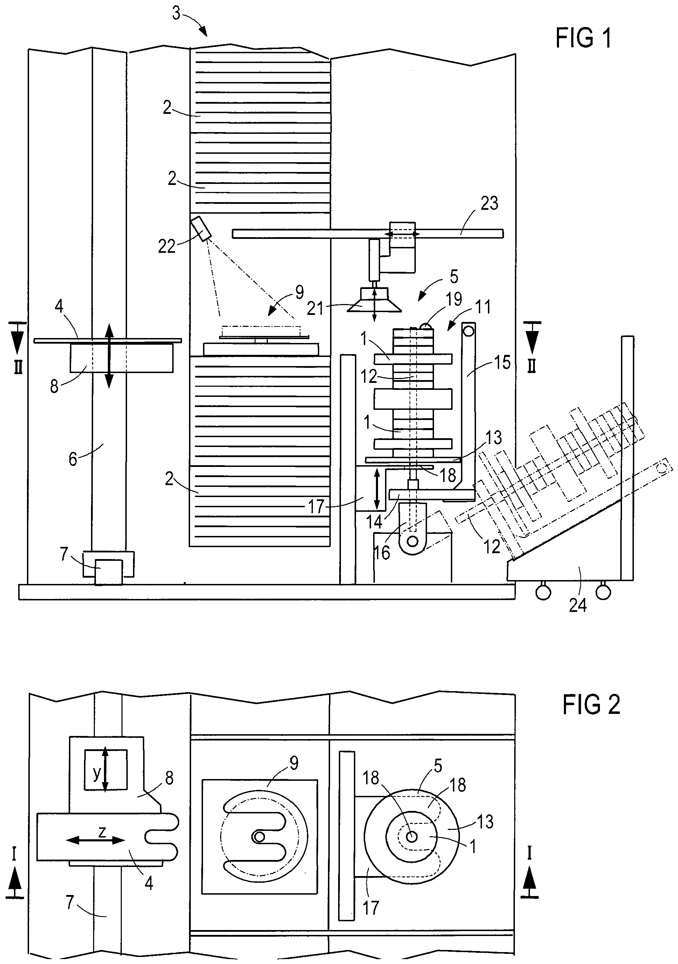

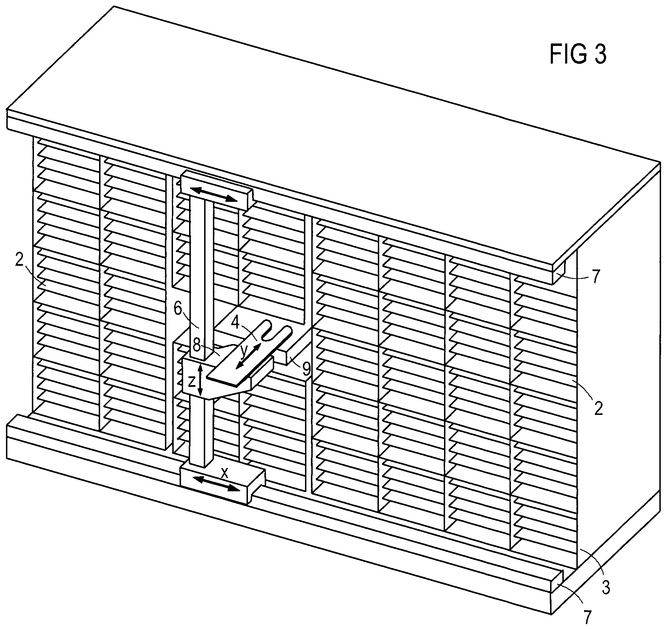

Die Figuren 1, 2 und 3 zeigen schematisiert eine Einrichtung zum Lagern und Bereitstellen von in Gurtspulen 1 aufgenommenen elektrischen Bauelementen. Die Gurtspulen 1 können in eine frontseitige Station 5 eingesetzt und vorn dort mittels einer Übergabevorrichtung 9 zu einer Zwischenablage 3 transportiert werden, von wo aus sie mittels eines rückseitig angeordneten Handhabungsroboters in zur Rückseite hin offenen Ablagefächern 2 einer flächenhaften senkrecht stehenden Regaleinrichtung 3 abgelegt werden können. Der Handhabungsroboter ist als orthogonale Positioniereinrichtung ausgebildet, die einen senkrechten schlanken Träger 6 aufweist, der in einer stationären Längsführung 7 der Einrichtung in einer waagerechten Längsrichtung y verfahrbar ist. Am Träger 6 ist in einer senkrechten Richtung z ein Wagen 8 verschiebbar, an dem ein plattenartiger flacher Schieber 4 in einer Einschubrichtung y verschiebbar geführt ist, die zur Verschiebeebene des Wagens 8 senkrecht orientiert ist. Die in der Zwischenablage 3 stirnseitig waagerecht aufliegende Gurtspule 1 kann vom Schieber 4 erfasst, zur freien Rückseite verschoben, auf das vorgesehene freie Ablagefach 2 eingestellt und in dieses eingeschoben werden.

Eine Mehrzahl der in der Station 5 bereitstehenden Gurtspulen 1 ist flachliegend in einem Magazin 11 senkrecht unmittelbar übereinander gestapelt, das aus einer senkrecht stehenden zentralen Stange 12, einer waagerechten Auflageplatte 13, einer waagerechten Grundplatte 14 und einem an der Grundplatte 14 verankerten Rahmen 15 besteht. Gurtspulen 1 unterschiedlicher Größe sind mit ihren einheitlichen Naben auf die Stange 12 aufgeschoben, wobei die unterste Gurtspule 1 auf der im Durchmesser größeren Auflageplatte 13 aufliegt. Ein verdickter Stangenabschnitt sorgt dafür, dass ein hinreichender Mindestabstand zwischen der Grundplatte 14 und der darüber liegenden Auflageplatte 13 eingehalten wird. Das aus der Grundplatte 14 nach unten herausragende Ende der Stange 12 ist in eine Bohrung eines Schwenkfußes 16 der Station 5 eingesteckt.

Die Übergabevorrichtung 9 weist eine senkrecht verschiebbaren Hubeinrichtung 17 mit einem waagerechten Hubarm 18 auf, der zwischen die Grundplatte 14 und die Auflageplatte 13 hineinragt und auf dem die Auflageplatte 13 mit ihrem Eigengewicht und dem Gewicht der gestapelten Gurtspulen 1 aufliegt. Der Hubarm 18 kann durch einen nicht näher dargestellten Hubantrieb auf und ab bewegt werden. Beim Eingeben der Gurtspulen 1 wird der Stapel durch die Hubeinrichtung 17 schrittweise nach oben geschoben, wobei die Oberseite der jeweils obersten Gurtspule 1 mit Hilfe einer Lichtschranke 19 auf ein definiertes Höhenniveau gebracht wird, das ungefähr in der Höhe der Zwischenablage 3 liegt.

Ein darüber senkrecht verschiebbarer Sauggreifer 21 der Übergabevorrichtung 9 kann mit seiner Unterseite auf die oberste der gestapelten Gurtspulen 1 aufgesetzt werden und diese aus dem Bereich der Stange 12 herausheben. Der Sauggreifer 21 ist entlang einer Linearführung 23 waagerecht zwischen dem Magazin 11 und der Zwischenablage 3 verschiebbar, auf welche die dem Magazin 11 entnommene Gurtspule 1 aufgelegt werden kann. Im Bereich der Zwischenablage 3 ist eine optische Sensoreinrichtung 22 vorgesehen, die die Größe und die Identität der jeweiligen Gurtspule 1 erfassen kann.

Der Schwenkfuß 16 ist um eine waagerechte Schwenkachse zwischen einer arretierbaren senkrechten Stellung und einer Kippstellung derart schwenkbar, dass das Magazin 11 aus einer strichpunktiert dargestellten gekippten Übergabestellung in seine senkrechte Arbeitsstellung geschwenkt werden kann. In der strichpunktiert angedeuteten Übergabestellung ist das Magazin 11 schräg zur Bedienseite der Einrichtung hin nach außen geneigt und kann in dieser Stellung auf einem Transportwagen 24 aufliegen, so dass das untere Ende der Stange 12 leicht in die Bohrung des Schwenkfußes 16 eingeführt werden kann. Am Rahmen 15 des Magazins 11 können geeignete Bediengriffe vorgesehen sein, so dass das Magazin 11 leicht seine Arbeitsstellung geschwenkt werden kann.

Die Ausgabe Gurtspulen 1 aus der Einrichtung kann mit den gleichen Funktionsteilen in umgekehrter Richtung erfolgen, wobei die Gurtspulen 1 z.B. für einen Verarbeitungsauftrag auf die Stange 12 aufgesteckt werden.

### Bezugszeichen

- x: Längsrichtung
- y: Einschubrichtung
- z: senkrechte Richtung
- 1: Gurtspule
- 2: Ablagefach
- 3: Regaleinrichtung
- 4: Schieber
- 5: Station
- 6: Träger
- 7: Längsführung
- 8: Wagen
- 9: Übergabevorrichtung
- 11: Magazin
- 12: Stange
- 13: Auflageplatte
- 14: Grundplatte
- 15: Rahmen
- 16: Schwenkfuß
- 17: Hubeinrichtung
- 18: Hubarm
- 19: Lichtschranke
- 21: Sauggreifer
- 22: Sensoreinrichtung
- 23: Linearführung
- 24: Transportwagen

## Patentansprüche

1. Einrichtung zum Lagern und Bereitstellen von in Gurtspulen (1) aufgenommenen elektrischen Bauelementen für elektronische Geräte,
wobei die Einrichtung zumindest eine Station (5) zur Eingabe und/oder Ausgabe der Gurtspulen (1) aufweist,
wobei die Einrichtung eine Regaleinrichtung (3) mit mehreren Ablagefächern (2) aufweist,
wobei die Einrichtung mit Transportmitteln versehen ist, durch welche die Gurtspulen (1) zwischen der Station (5) und den Ablagefächern (2) der Regaleinrichtung transportierbar sind, **dadurch gekennzeichnet,**
**dass** die Station (5) Aufnahmemittel aufweist, die als wechselbares Magazin (11) ausgebildet und dazu eingerichtet sind, eine Mehrzahl von Gurtspulen (1) unterschiedlicher Größe aufzunehmen, wobei das Magazin eine senkrecht stellbare Stange aufweist, auf der Gurtspulen (1) unterschiedlicher Größe mit ihren zentralen Naben in ihrer Achsrichtung aneinandergereiht aufsteckbar sind,
**dass** die Gurtspulen (1) unterschiedlicher Größe durch die Transportmittel einzeln aus den Aufnahmemitteln entnehmbar oder in diese einlegbar sind, und dass die Gurtspulen (1) im senkrecht stehenden Magazin (11) waagerecht liegend unmittelbar senkrecht übereinander stapelbar sind.

2. Einrichtung nach Anspruch 1, **dadurch gekennzeichnet,**
**dass** die Transportmittel zumindest eine Übergabevorrichtung (9) und einen auf die Ablagefächer (2) zugreifenden Handhabungsroboter aufweisen,
**dass** die Gurtspulen (1) durch die Übergabevorrichtung (9) zwischen der Station (5) und einer Übergabeposition transportierbar sind, in der sie an den Handhabungsroboter übergebbar sind und/oder in der die vom Handhabungsroboter aus den Ablagefächern (2) entnommenen Gurtspulen (1) an die Übergabevorrichtung (9) übergebbar sind.

3. Einrichtung nach Anspruch 2, **dadurch gekennzeichnet,**
**dass** die Übergabevorrichtung (9) einen Sauggreifer (21) aufweist, der an eine flache Stirnseite eines Spulenkörpers jeweils einer der Gurtspulen (1) ansetzbar ist.

4. Einrichtung nach Anspruch 3, **dadurch gekennzeichnet,**
**dass** die Übergabevorrichtung (9) in der Übergabeposition eine Zwischenablage (3) für zumindest eine der Gurtspulen (1) aufweist,
**dass** der Sauggreifer (21) zwischen der Station (5) und der Zwischenablage (3) verschiebbar ist und
**dass** die Zwischenablage (3) zum Zugriff des Handhabungsroboters auf diese Gurtspule 1 ausgebildet ist.

5. Einrichtung nach Anspruch 1, **dadurch gekennzeichnet, dass** die Gurtspulen (1) in dem Magazin (11) senkrecht verschiebbar gelagert sind und dass die Übergabevorrichtung (9) eine an der Unterseite des Stapels ansetzende Hubeinrichtung (17) zum Anheben oder Absenken des Stapels aufweist.

6. Einrichtung nach einem der vorhergehenden Ansprüche, **dadurch gekennzeichnet,**
**dass** das Magazin (11) mit seinem unteren Ende an einem Schwenkfuß (16) der Station (5) zur Außenseite der Einrichtung hin kippbar gelagert ist und dass der Schwenkfuß (16) in der senkrechten Magazinstellung arretierbar ist.

7. Einrichtung nach einem der vorhergehenden Ansprüche, **dadurch gekennzeichnet,**
**dass** das Magazin (11) eine untere waagerechte Auflageplatte (13) für die Gurtspulen (1) aufweist, die an der Stange (12) verschiebbar gelagert ist.

8. Einrichtung nach Anspruch 7, **dadurch gekennzeichnet, dass** die Stange (12) in einer Grundplatte (14) des Magazins (11) verankert ist, an der ein Rahmen (15) zur manuellen Handhabung des Magazins (11) befestigt ist.

9. Einrichtung nach Anspruch 8, **dadurch gekennzeichnet, dass** ein unteres Ende der Stange (12) aus der Grundplatte (14) herausragt und in eine Bohrung des Schwenkfußes (16) einsteckbar ist.

10. Einrichtung nach einem der vorhergehenden Ansprüche, ferner umfassend einen Transportwagen für ein Magazin, wobei der Transportwagen (24) Mittel zur gekippten Auflage des Magazins (11) aufweist.

## Claims

1. A device for mounting and providing electrical components for electronic items of equipment accommodated in belt coils (1),
wherein the device has at least one station (5) for the entrance and/or exit of belt coils (1),
wherein the device has a racking device (3) with a plurality of storage compartments (2),
wherein the device is provided with transport means through which the belt coils (1) can be transported between the station (5) and the storage compartments (2) of the racking device, **characterised in that**
the station (5) has accommodating means which are designed as an exchangeable magazine (11) and set up to accommodate a plurality of belt coils (1) of different sizes, wherein the magazine has a rod which can be adjusted perpendicularly, onto which belt coils (1) of different sizes can be attached with their central hubs strung together in axial direction,
the belt coils (1) of different sizes can be removed individually from the accommodating means by the transport means or can be inserted into same, and
the belt coils (1) can be stacked directly perpendicularly one on top of the other in the perpendicular magazine (11), lying horizontally.

2. The device according to claim 1, **characterised in that**
the transport means have at least one transfer device (9) and a handling robot accessing the storage compartments (2),
the belt coils (1) can be transported between the station (5) and a transfer position in which they can be transferred to the handling robot by the transfer device (9), and/or into which the belt coils (1) removed from the storage compartments (2) by the handling robot can be transferred to the transfer device (9).

3. The device according to claim 2, **characterised in that**
the transfer device (9) has a vacuum gripper (21) which can be attached to a flat end side of a coil body on each belt coil (1).

4. The device according to claim 3, **characterised in that**
the transfer device (9) has temporary storage (3) in the transfer position for at least one of the belt coils (1),
the vacuum gripper (21) can be displaced between the station (5) and the temporary storage (3) and
the temporary storage (3) is designed for the handling robot to be able to access this belt coil 1.

5. The device according to claim 1, **characterised in that** the belt coils (1) are mounted in perpendicularly displaceable manner in the magazine (11) and the transfer device (9) has a lifting device (17) attaching to the underside of the stack for raising the stack up or down.

6. The device according to one of the preceding claims, **characterised in that**
the magazine (11) is mounted with its bottom end tiltable to the outside on a swivel base (16) of the station (5) and the swivel base (16) can be locked in the perpendicular magazine position.

7. The device according to one of the preceding claims, **characterised in that**
the magazine (11) has a lower horizontal support plate (13) for the belt coils (1), which plate is mounted displaceable on the rod (12).

8. The device according to claim 7, **characterised in that**
the rod (12) is embedded in a base plate (14) of the magazine (11), onto which plate a frame (15) is fixed for manually handling the magazine (11).

9. The device according to claim 8, **characterised in that**
a bottom end of the rod (12) protrudes out of the base plate (14) and can be inserted into a bore of the swivel base (16).

10. The device according to one of the preceding claims, further comprising a transport trolley for a magazine, wherein the transport trolley (24) has means for tilted support of the magazine (11).

## Revendications

1. Dispositif pour stocker et préparer des composants électriques logés dans des bobines à bande (1) pour des appareils électroniques,
dans lequel le dispositif comporte au moins une station (5) pour l'entrée et/ou la sortie des bobines à bande (1),
dans lequel le dispositif comporte un dispositif à rayonnage (3) avec plusieurs casiers (2),
dans lequel le dispositif est pourvu de moyens de transport par lesquels les bobines à bande (1) peuvent être transportées entre la station (5) et les casiers (2) du dispositif à rayonnage, **caractérisé**
**en ce que** la station (5) comporte des moyens de réception qui sont formés comme un magasin remplaçable (11) et qui sont installés pour recevoir une multiplicité de bobines à bande (1) de différentes tailles, dans lequel le magasin comporte une barre apte à être posée à la verticale, sur laquelle des bobines à bande (1) de différentes tailles peuvent être enfilées dans sa direction axiale en étant alignées avec leurs moyeux centraux,
**en ce que** les bobines à bande (1) de différentes tailles peuvent être prises ou placées individuellement dans les moyens de réception par les moyens de transport, et
**en ce que** les bobines à bande (1) peuvent être empilées directement à la verticale en étant placées à l'horizontale dans le magasin posé à la verticale (11).

2. Dispositif selon la revendication 1, **caractérisé**
**en ce que** les moyens de transport comportent au moins un dispositif de transfert (9) et un robot de manipulation accédant aux casiers (2),
**en ce que** les bobines à bande (1) peuvent être transportées par le dispositif de transfert (9) entre la station (5) et une position de transfert dans laquelle elles peuvent être transférées au robot de manipulation et/ou dans laquelle les bobines à bande (1) prises par le robot de manipulation dans les casiers (2) peuvent être transférées au dispositif de transfert (9).

3. Dispositif selon la revendication 2, **caractérisé**
**en ce que** le dispositif de transfert (9) comporte une ventouse (21) qui peut être appliquée contre un côté frontal plat d'un corps de l'une des bobines à bande (1).

4. Dispositif selon la revendication 3, **caractérisé**
**en ce que** le dispositif de transfert (9) comporte dans la position de transfert une tablette intermédiaire (3) pour l'une au moins des bobines à bande (1),
**en ce que** la ventouse (21) peut être déplacée entre la station (5) et la tablette intermédiaire (3) et
**en ce que** la tablette intermédiaire (3) est formée pour que le robot de manipulation accède à la bobine à bande (1).

5. Dispositif selon la revendication 1, **caractérisé**
**en ce que** les bobines à bande (1) sont montées dans le magasin (11) en pouvant être déplacées à la verticale et en ce que le dispositif de transfert (9) comporte un dispositif de levage (17) qui s'applique contre le côté inférieur de l'empilement, pour soulever ou abaisser celui-ci.

6. Dispositif selon l'une des revendications précédentes, **caractérisé**
**en ce que** le magasin (11) est monté basculant avec son extrémité inférieure sur une base pivotante (16) de la station (5) en direction du côté extérieur du dispositif, et
**en ce que** la base pivotante (16) peut être arrêtée dans la position de magasin verticale.

7. Dispositif selon l'une des revendications précédentes, **caractérisé**
**en ce que** le magasin (11) comporte une plaque de support horizontale inférieure (13) pour les bobines à bande (1) qui sont montées mobiles sur la barre (12).

8. Dispositif selon la revendication 7, **caractérisé**
**en ce que** la barre (12) est ancrée dans une plaque de base (14) du magasin (11) sur laquelle est fixé un châssis (15) pour la manipulation manuelle du magasin (11).

9. Dispositif selon la revendication 8, **caractérisé**
**en ce qu'**une extrémité inférieure de la barre (12) dépasse de la plaque de base (14) et peut être introduite dans un perçage de la base pivotante (16).

10. Dispositif selon l'une des revendications précédentes, comprenant également un chariot de transport pour un magasin, dans lequel le chariot de transport (24) comporte des moyens pour le support basculé du magasin (11).
